# EUROPEAN PATENT APPLICATION

(11) **EP 4 053 219 A1**
(43) Date of publication of application: **07.09.2022**
(21) Application number: 20934920.8
(22) Date of filing: 24.12.2020
(51) Int. Cl.: C08L 77/06, C08L 81/02, C08L 51/06, C08L 53/02, C08L 91/06, C08J 5/18, H05K 1/03

(54) **LIQUID CRYSTAL POLYMER FILM FOR FLEXIBLE PRINTED CIRCUIT BOARD**

(30) Priority: 09.05.2020 CN 202010386569
(71) Applicant: Ningbo Solartron Technology Co., Ltd., Ningbo, Zhejiang 315031 (CN)
(72) Inventor: JIN, Yadong, Ningbo City, Zhejiang 315031 (CN); YANG, Chenghan, Ningbo City, Zhejiang 315031 (CN); ZHOU, Yubo, Ningbo City, Zhejiang 315031 (CN); WANG, Xiongwei, Ningbo City, Zhejiang 315031 (CN); ZHU, Zhengping, Ningbo City, Zhejiang 315031 (CN)
(74) Representative: Petraz, Gilberto Luigi
(86) International application number: PCT/CN2020/138793
(87) International publication number: WO 2021/227505

(57) **Abstract**

The present invention provides a liquid crystal polymer film for a flexible printed circuit board. The material of the liquid crystal polymer film comprises poly para-phenylene terephthalamide resin and polyphenylene sulfide resin, the longitudinal tensile strength of the liquid crystal polymer film is smaller than the transverse tensile strength thereof, and the longitudinal elongation at break of the liquid crystal polymer film is larger than the transverse elongation at break thereof.

## Description

### CROSS-REFERENCE TO RELATED APPLICATION

This application claims all benefits of the priority from China Patent Application No. 202010386569.1, filed on May 9, 2020, in the China National Intellectual Property Administration, and titled "LIQUID CRYSTAL POLYMER FILM FOR FLEXIBLE PRINTED CIRCUIT BOARD" the content of which is hereby incorporated by reference.

### TECHNICAL FIELD

The present invention relates to a field of printed circuit board, in particular to a liquid crystal polymer film for a flexible printed circuit board.

### BACKGROUND

With rapid development of electronic information products, especially 5G industries such as micron-wave equipment, requirements for flexible printed circuit boards (FPC) are growing higher and higher. In a conventional flexible printed circuit board, a substrate is usually made of polyimide film. However, a dielectric constant of the polyimide film is usually about 4.0, and a dielectric dissipation factor thereof is usually in a range of 0.004 to 0.007. Both the dielectric constant and the dielectric dissipation factor of the conventional flexible printed circuit board are high, which cannot meet the requirements of flexible printed circuit board in high frequency applications.

### SUMMARY

According to various embodiments of the present invention, a liquid crystal polymer film for a flexible printed circuit board is provided. The material of the liquid crystal polymer film includes a poly para-phenylene terephthalamide resin and a polyphenylene sulfide resin. A longitudinal tensile strength of the liquid crystal polymer film is less than a transverse tensile strength thereof, and a longitudinal elongation at break of the liquid crystal polymer film is greater than a transverse elongation at break thereof.

In one embodiment, the longitudinal tensile strength of the liquid crystal polymer film is in a range of 0.83 times to 0.92 times of the transverse tensile strength thereof; and/or, the longitudinal elongation at break of the liquid crystal polymer film is in a range of 1.05 times to 1.13 times of the transverse elongation at break thereof.

In one embodiment, the longitudinal elongation at break of the liquid crystal polymer film is 55% to 65%, and the transverse elongation at break of the liquid crystal polymer film is 54% to 61%; and/or, the longitudinal tensile strength of the liquid crystal polymer film is in a range of 120 MPa to 190 MPa, and the transverse tensile strength of the liquid crystal polymer film is in a range of 145 MPa to 200 MPa.

In one embodiment, a difference value between the longitudinal elongation at break of the liquid crystal polymer film and the transverse elongation at break of the liquid crystal polymer film is less than or equal to 7%.

In one implementation, a difference value between the transverse tensile strength of the liquid crystal polymer film and the longitudinal tensile strength of the liquid crystal polymer film is less than or equal to 30MPa.

In one embodiment, the liquid crystal polymer film has a dielectric constant in a range of 2.5 to 2.8 and a dielectric dissipation factor in a range of 0.001 to 0.002 at 50 GHz.

In one implementation, a coefficient of thermal expansion of the liquid crystal polymer film is in a range of 10 ppm/K to 14 ppm/K, and a longitudinal coefficient of thermal expansion of the liquid crystal polymer film is in a range of 90% to 110% times of a transverse coefficient of thermal expansion of the liquid crystal polymer film.

In one implementation, a mass percentage of the polyphenylene sulfide resin in the liquid crystal polymer film is in a range of 9% to 29.8%.

In one implementation, the material of the liquid crystal polymer film further includes an auxiliary, which includes a compatibilizer and a dispersant. A mass percentage of the compatibilizer in the liquid crystal polymer film is in a range of 2% to 5%, and a mass percentage of the dispersant in the liquid crystal polymer film is in a range of 0.2% to 1%.

In one implementation, the compatibilizer includes grafted copolymer ethylene-butylene-g-MAH, and a grafting rate of the grafted copolymer ethylene-butylene-g-MAH is greater than or equal to 0.5%.

The liquid crystal polymer film of the present invention is mainly obtained by blending a poly para-phenylene terephthalamide resin (LCP resin) and a polyphenylene sulfide resin (PPS resin), and has an extremely low dielectric constant and an extremely low dielectric dissipation factor. Meanwhile, the longitudinal tensile strength of the liquid crystal polymer film is less than the transverse tensile strength thereof, and the longitudinal elongation at break of the liquid crystal polymer film is greater than the transverse elongation at break thereof, such that the transverse and longitudinal tensile strengths of the liquid crystal polymer film and the transverse and longitudinal elongations at break of the liquid crystal polymer film are complementary, and the mechanical properties of the liquid crystal polymer film are ensured to be isotropic.

Furthermore, in the present invention, the liquid crystal polymer film can be used as the substrate material of a flexible printed circuit board, so that the flexible printed circuit board has excellent dielectric properties and mechanical properties, and meets requirements of high frequency application fields (in a range of 15GHz to 100GHz).

### DETAILED DESCRIPTION

A clear and complete description of the technical solutions in the implementations of the present invention will be given below in conjunction with the accompanying drawings in the implementations of the present invention. It will be apparent that the described implementations are only a part and not all of the implementations of the present invention. Based on the implementations in the present invention, all other implementations obtained by those of ordinary skill in the art without creative work fall within the protection scope of the present invention.

Unless otherwise defined, all technical and scientific terms used herein have the same meaning as commonly understood by one of ordinary skill in the art of the present invention. Terms used herein in the discription of the present invention are for the purpose of describing specific embodiments only and are not intended to limit the present invention. The term "or/and" as used herein includes any and all combinations of one or more of the associated listed items.

Liquid crystal polymer film has extremely low dielectric constant and dielectric dissipation at high frequencies (in a range of 15GHz to 100GHz), and has characteristics of flexibility of organic polymer materials. In addition, the liquid crystal polymer film exhibits liquid crystallinity in a molten state, and has advantages of excellent heat resistance, extremely low hygroscopicity, dimensional stability, low coefficient of thermal expansion, etc. Thus, liquid crystal polymer film is ideal material for a substrate of a flexible printed circuit board.

However, upon a condition that the liquid crystal polymer film is used as the material of the substrate of the flexible printed circuit board, the substrate is always rapidly damaged along a transverse direction during a service process of the flexible printed circuit board, resulting in a short service life of the flexible printed circuit board. After a long-term and in-depth research, the applicant found that the reason why the transverse portion of the substrate is always rapidly damaged is that a shearing force during a preparation process may cause the liquid crystal polymer film to have a high degree of orientation. In particular, the liquid crystal polymer has high mechanical property in a MD (a machine direction, which is also called longitudinal direction), but poor mechanical property in a TD direction (a transverse direction), making the liquid crystal polymer film exhibit anisotropy.

To this end, in the flexible printed circuit board provided by the present invention, the liquid crystal polymer film is used as a base material. In addition, the material of the liquid crystal polymer film includes poly para-phenylene terephthalamide resin and polyphenylene sulfide resin. A longitudinal tensile strength of the liquid crystal polymer film is less than a transverse tensile strength thereof, and a longitudinal elongation at break of the liquid crystal polymer film is greater than a transverse elongation at break thereof.

In particular, the PPS resin has a high flowability and an excellent processability. When the PPS resin is blended with the LCP resin, a synergistic effect may occur between the PPS resin and the LCP resin, reducing the influence of the shear force in the preparation process. The result is as follows: the transverse tensile strength of the liquid crystal polymer film is greater than the longitudinal tensile strength thereof, and the longitudinal elongation at break of the liquid crystal polymer film is greater than the transverse elongation at break thereof, which directly changes the distribution form of mechanical strength of the liquid crystal polymer film. Thus, the liquid crystal polymer film exhibits isotropy through complementarity of the longitudinal and the transverse tensile strengths and the longitudinal and the transverse elongations at break. Therefore, upon a condition that the liquid crystal polymer film is used as the material of the insulating substrate of the flexible printed circuit board, the substrate may not be rapidly damaged in a certain direction when the flexible printed circuit board undergoes mechanical deformation during service.

In order to make the transverse and the longitudinal mechanical properties of the liquid crystal polymer film close to each other and to reduce the manufacturing cost of the isotropic liquid crystal polymer film, the longitudinal tensile strength is in a range of 0.83 times to 0.92 times, and more optionally, 0.86 times of the transverse tensile strength of the liquid crystal polymer film. The longitudinal elongation at break of the liquid crystal polymer film is in a range of 1.05 times to 1.13 times of the transverse elongation at break, and more optionally, 1.07 times of the transverse elongation at break of the liquid crystal polymer film.

In order to satisfy a using strength of the flexible printed circuit board while reducing the difficulty of achieving isotropy by complementarity of the longitudinal elongation at break and the transverse elongation at break, the longitudinal tensile strength of the liquid crystal polymer film is optionally in a range of 120 MPa to 190 MPa, and more optionally, in a range of 150 MPa to 190 MPa; and the transverse tensile strength of the liquid crystal polymer film is optionally in a range of 145 MPa to 200 MPa, and more optionally, in a range of 180 MPa to 200 MPa.

In addition, in order to enable the elongation at break to be complementary to the tensile strength and ensure that the liquid crystal polymer film is isotropic, a difference between the transverse tensile strength of the liquid crystal polymer film and the longitudinal tensile strength thereof should not be too great. Therefore, in the present invention, a difference value between the transverse tensile strength of the liquid crystal polymer film and the longitudinal tensile strength thereof is optionally less than or equal to 30 MPa, and more optionally, less than or equal to 25 MPa.

In the above range of tensile strength, when the elongation at break is too high, deformation amount of the liquid crystal polymer film may be too large, thus the complementary effect of the elongation at break with the tensile strength is lost. Therefore, the longitudinal elongation at break of the liquid crystal polymer film is optionally in a range of 55% to 65%, and more optionally, in a range of 60% to 65%; and the transverse elongation at break of the liquid crystal polymer film is optionally in a range of 54% to 61%, and more optionally, in a range of 58% to 61%.

In consideration of the complementary effect, the difference value between the longitudinal elongation at break of the liquid crystal polymer film and the transverse elongation at break thereof is optionally less than or equal to 7%, and more optionally, less than or equal to 3%.

Of course, in addition to blending the PPS resin with LCP resin such that the tensile strength of the liquid crystal polymer film and elongation at break thereof complement each other, it is also need to ensure the dielectric property of the liquid crystal polymer film. Thus, a mass percentage of the PPS resin in the liquid crystal polymer film is in a range of 9% to 29.8%. Therefore, the liquid crystal polymer film has a dielectric constant in a range of 2.5 to 2.8 and a dielectric dissipation factor in a range of 0.001 to 0.002 at 50 GHz, which is suitable for a high frequency flexible printed circuit board.

Meanwhile, a coefficient of thermal expansion (CTE) of the liquid crystal polymer film is in a range of 10 ppm/K to 14 ppm/K, and a longitudinal coefficient of thermal expansion of the liquid crystal polymer film is in a range of 90% to 110% times of a transverse coefficient of thermal expansion thereof, thus the liquid crystal polymer film is also isotropic. Therefore, when the liquid crystal polymer film is used as the material of the insulating substrate of the flexible printed circuit board, the liquid crystal polymer film will not be rapidly damaged in a certain direction even when the flexible printed circuit board undergoes thermal deformation during service process.

Therefore, when the liquid crystal polymer film provided by the present invention is used as the material of the insulating substrate of the flexible printed circuit board, it has excellent dielectric performance. Thus, the substrate of the flexible printed circuit board will not be rapidly damaged in a certain direction during service process, and the service life thereof is long.

It is difficult to obtain an isotropic liquid crystal polymer film with a thickness greater than or equal to 50 µm by a conventional method such as a blow molding method, and requirements of the flexible printed circuit board cannot be meet. The isotropic liquid crystal polymer film used in the flexible printed circuit board of the present invention may be prepared with reference to the following preparation methods.

S1, a poly para-phenylene terephthalamide resin and a polyphenylene sulfide resin are mixed to obtain a mixture, the mixture are melt and plasticized, and then cast to obtain pre-prepared film.

S2, the pre-prepared film is biaxially stretched to obtain the liquid crystal polymer film.

In step S1, a mass percentage of the polyphenylene sulfide resin in the mixture is in a range of 9% to 29.8%.

In some embodiments, the mixture further includes an auxiliary, which includes a compatibilizer and a dispersant. A mass percentage of the auxiliary in the mixture is in a range of 2.2% to 6%.

Wherein a mass percentage of the compatibilizer in the mixture is in a range of 2% to 5%, and the compatibilizer includes a grafted copolymer ethylene-butylene-g-MAH, and a grafting rate of the grafted copolymer ethylene-butylene-g-MAH is greater than or equal to 0.5%. Therefore, by grafting reactive groups that have strong polarity on the maleic anhydride, extension of molecular chains may be facilitated and polarity of the molecular chains may be improved, so that the LCP resin and the PPS resin may be better blended, and polymer orientation crystallization may be limited, thereby preventing the pre-prepared film from cracking during stretching.

A mass percentage of the dispersant in the mixture is in a range of 0.2% to 1%, and the dispersant includes Mondane wax. Thus, through very long non-polar carbon chains with very strong polar centers in the Mondan wax, parts of the structure of the Mondan wax that are compatible with plastics on the polar segments play an internal lubrication role, and have low volatility, which adversely affects a melt tension and a Vicat softening point of the resin. Therefore, the Mondan wax dispersant may make the PPS resin more uniformly dispersed in LCP resin, and may improve a fluidity of the liquid crystal polymer film during processing.

Specifically, the melting and plasticizing process may be performed by a twin-screw extruder. Wherein a temperature of the mixture is in a range of 100 degrees centigrade to 300 degrees centigrade, a temperature of a die head of the twin-screw extruder is in a range of 290 degrees centigrade to 300 degrees centigrade, and a temperature of a cold roller in the twin-screw extruder is in a range of 220 degrees centigrade to 260 degrees centigrade.

In step S2, the liquid crystal polymer film is prepared by a biaxial stretching process, which is beneficial to an orientation setting of the polymer in the LCP resin and the PPS resin, and improves the crystallinity and the fineness of the crystallization of the polymer, thereby greatly improving mechanical strength and transparency of the liquid crystal polymer film.

Specifically, in the biaxial stretching process, the longitudinal stretching ratio of the pre-prepared film is in a range of 1.5 to 3.0, and the transverse stretching ratio is in a range of 2.0 to 3.5.

The longitudinal stretching ratio refers to a ratio between the longitudinal length of the film after stretching and the longitudinal length of the film before stretching, and the transverse stretch ratio refers to a ratio between the transverse length of the film after stretching and the transverse length of the film before stretching.

In some embodiments, in the biaxial stretching process, a longitudinal stretching process is firstly performed so that the polymer is longitudinally oriented first, and then a transverse stretching process is performed to obtain a liquid crystal polymer film. A longitudinal stretching strength of the liquid crystal polymer film is smaller than a transverse stretching strength thereof, and a longitudinal elongation at break of the liquid crystal polymer film is greater than a transverse elongation at break thereof.

Specifically, a stretching temperature of the biaxial stretching process is in a range of 240 degrees centigrade to 270 degrees centigrade, and under the stretching temperature, which is above a glass transition temperature of the mixture and below a melting point of the mixture, the polymer film can be stretched.

Specifically, the liquid crystal polymer film prepared by this method has a thickness in a range of 50 µm to100 µm, a melting point (Tm) in a range of 270 degrees centigrade to 290 degrees centigrade, and a water absorption in a range of 0.03% to 0.04% (25 degrees centigrade, immersion in water for 24h).

Therefore, the production process for preparing the isotropic liquid crystal polymer film of the present invention is simple and low-cost, and the prepared liquid crystal polymer film is suitable for manufacturing the substrate of the flexible printed circuit board.

Hereinafter, the flexible printed circuit board provided in the present invention will be further explained by the following specific examples.

The material of the liquid crystal polymer film was commercially available from the following companies.
1) LCP resin was purchased from Japanese Polyplastics Co., Ltd. under the brand name A950RX.
2) PPS resin was purchased from Japanese Polyplastics Co., Ltd., under the brand name DURAFIDE 1130A64.
3) The compatibilizer was purchased from American Kraton Corporation, under the brand name FG1901.
4) The dispersant was purchased from BASF SE of Germany, under the brand name Luwax OP.

A melting point of LCP resin was 280 degrees centigrade, a melt viscosity of LCP was 155 Pa·S under the condition of a shear rate of 100s⁻¹, and the melt viscosity was 45 Pa·S under a condition of a shear rate of 1000s⁻¹.

PPS resin had a high fluidity, a glass transition temperature (Tg) of 150 degrees centigrade and a melting point (Tm) of 280 degrees centigrade.

The compatibilizer was maleic anhydride (MAH) grafted ethylene-butene copolymer (SEBS), which had a grafting ratio of greater than or equal to 0.5.

The dispersant was Mondan wax with a melting point of 100 degrees centigrade and a viscosity of 300 mPa·S at 100 degrees centigrade.

Each performance measurement method was as follows. Thickness: the thickness was measured by adopting *GB*/*T 6672-2001 Plastic film and sheeting-Determination of thickness by mechanical scanning.* Coefficient of thermal expansion: the coefficient of thermal expansion was measured by adopting *ISO 11359-2-1999 Plastic-Thermomechanical analysis (TMA)-Part 2: Determination of coefficient of linear thermal expansion and glass transition temperature,* using instrument of PerkinElmer's TMA 4000. Melting point: the melting point of polymer is measured by adopting *GB*/*T19466.1-2004 Plastics- Differential scanning calorimetry (DSC),* using an equipment of NETZSCH of Germany with a model of DSC214. Water absorption: the water absorption of plastics was measured by adopting *ASTM D570 Standard Test Method for Water Absorption of Plastics*, and the measurement was carried out when plastics is immersed in water for 24 hours at 25 degrees centigrade. Dielectric constant Dk and dielectric dissipation factor Df: the dielectric constant Dk and the dielectric dissipation factor Df are measured by adopting *GB*/*T 1409-2006 Recommended methods for determination of the permittivity and dielectric dissipation factor of electrical insulating materials at power, audio, and audio frequency including meter wavelengths,* using QS37a rubber plastic film dielectric constant testing instrument of Beijing zhidechuangxin Instrument and Equipment Co., Ltd., at 50GHz. Tensile strength and elongation at break: the tensile strength and the elongation at break are measured by adopting *GB*/*T1040.1 Plastic-Determination of tensile properties*, using INSTRON universal material testing machine produced by INSTRON Limited of the United States. Folding endurance: the folding endurance was measured by adopting *GB*/*T 2679.5 Paper and board-Determination of folding endurance (MIT tester).*

### Embodiment 1

By mass ratio, 75% of A950RX, 21% of DURAFIDE 1130A64, 3% of FG1901, and 1% of Luwax OP were mixed to form a mixture. The mixture was placed in a twin-screw extruder for melting and plasticization. A temperature of the mixture in the twin-screw extruder was in a range of 100 degrees centigrade to 300 degrees centigrade, a temperature of a die head was in a range of 290 degrees centigrade to 300 degrees centigrade, and a temperature of a cold roll was 240 degrees centigrade. After melting and plasticization, the pre-prepared material was then cast to obtain a pre-prepared film.

The pre-prepared film was first stretched longitudinally at a stretching ratio of 2.5, and then stretched transversely at a stretching ratio of 3, under a stretching temperature of 240 degrees centigrade. After stretching, the pre-prepared film was wound and slit transversely to obtain a liquid crystal polymer film with a thickness of 50 µm.

The above liquid crystal polymer film was used as a substrate material of a flexible printed circuit board to prepare the flexible printed circuit board.

### Embodiment 2

By mass ratio, 80% of A950RX, 17.5% of DURAFIDE 1130A64, 2% of FG1901, and 0.5% of Luwax OP were mixed to form a mixture. The mixture was placed in a twin-screw extruder for melting and plasticization. A temperature of the mixture in the twin-screw extruder was in a range of 100 degrees centigrade to 300 degrees centigrade, a temperature of a die head was in a range of 290 degrees centigrade to 300 degrees centigrade, and a temperature of a cold roll was 220 degrees centigrade. After melting and plasticization, the pre-prepared material was then cast to obtain a pre-prepared film.

The pre-prepared film was first stretched longitudinally at a stretching ratio of 2, and then stretched transversely at a stretching ratio of 2.5, under a stretching temperature of 250 degrees centigrade. After stretching, the pre-prepared film was wound and slit transversely to prepare a liquid crystal polymer film with a thickness of 80 µm.

The above liquid crystal polymer film was used as a substrate material of a flexible printed circuit board to prepare a flexible printed circuit board.

### Embodiment 3

By mass ratio, 85% of A950RX, 12.5% of DURAFIDE 1130A64, 2% of FG1901, and 0.5% of Luwax OP were mixed to form a mixture. The mixture was placed in a twin-screw extruder for melting and plasticization. A temperature of the mixture in the twin-screw extruder was in a range of 100 degrees centigrade to 300 degrees centigrade, a temperature of a die head was in a range of 290 degrees centigrade to 300 degrees centigrade, and a temperature of a cold roll was 220 degrees centigrade. After melting and plasticization, the pre-prepared material was then cast to obtain a pre-prepared film.

The pre-prepared film was first stretched longitudinally at a stretching ratio of 3, and then stretched transversely at a stretching ratio of 3, under a stretching temperature of 260 degrees centigrade. After stretching, the pre-prepared film was wound and slit transversely to prepare a liquid crystal polymer film with a thickness of 100 µm.

The above liquid crystal polymer film was used as a substrate material of a flexible printed circuit board to prepare a flexible printed circuit board.

### Embodiment 4

By mass ratio, 90% of A950RX, 7.8% of DURAFIDE 1130A64, 2% of FG1901, and 0.2% of Luwax OP were mixed to form a mixture. The mixture was placed in a twin-screw extruder for melting and plasticization. A temperature of the mixture in the twin-screw extruder was in a range of 100 degrees centigrade to 300 degrees centigrade, a temperature of a die head was in a range of 290 degrees centigrade to 300 degrees centigrade, and a temperature of a cold roll was 220 degrees centigrade. After melting and plasticization, the pre-prepared material was then cast to obtain a pre-prepared film.

The pre-prepared film was first stretched longitudinally at a stretching ratio of 3, and then stretched longitudinally at a ratio of 3.5, under a stretching temperature of 270 degrees centigrade. After stretching, the pre-prepared film was wound and slit transversely to prepare a liquid crystal polymer film with a thickness of 100 µm.

The above liquid crystal polymer film was used as a substrate material of a flexible printed circuit board to prepare the flexible printed circuit board.

### Embodiment 5

By mass ratio, 90% of A950RX, 7% of DURAFIDE 1130A64, 2% of FG1901, and 1% of Luwax OP were mixed to form a mixture. The mixture was placed in a twin-screw extruder for melting and plasticization. A temperature of the mixture in the twin-screw extruder was in a range of 100 degrees centigrade to 300 degrees centigrade, a temperature of a die head was in a range of 290 degrees centigrade to 300 degrees centigrade, and a temperature of a cold roll was 220 degrees centigrade. After melting and plasticization, the pre-prepared material was then cast to obtain a pre-prepared film.

The pre-prepared film was first stretched longitudinally at a stretching ratio of 2.7, and then stretched transversely at a stretching ratio of 3.0, under a stretching temperature of 280 degrees centigrade. After stretching, the pre-prepared film was wound and slit transversely to prepare a liquid crystal polymer film with a thickness of 100 µm.

The above liquid crystal polymer film was used as the substrate material of the flexible printed circuit board to prepare the flexible printed circuit board.

### Embodiment 6

By mass ratio, 70% of A950RX, 24.8% of DURAFIDE 1130A64, 5% of FG1901, and 0.2% of Luwax OP were mixed to form a mixture. The mixture was placed in a twin-screw extruder for melting and plasticization. A temperature of the mixture in the twin-screw extruder was in a range of 100 degrees centigrade to 300 degrees centigrade, a temperature of a die head was 290 degrees centigrade to 300 degrees centigrade, and a temperature of a cold roll was 220 degrees centigrade. After melting and plasticization, the pre-prepared material was then cast to obtain a pre-prepared film.

The pre-prepared film was first stretched longitudinally at a stretching ratio of 1.5, and then stretched transversely at a stretching ratio of 1.9, under a stretching temperature of 270 degrees centigrade. After stretching, the pre-prepared film was wound and slit transversely to prepare a liquid crystal polymer film with a thickness of 100 µm.

The above liquid crystal polymer film was used as a substrate material of a flexible printed circuit board to prepare a flexible printed circuit board.

The properties of the liquid crystal polymer film and the flexible circuit board obtained in Embodiment s 1-6 are measured, and the results were shown in Table 1.

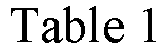

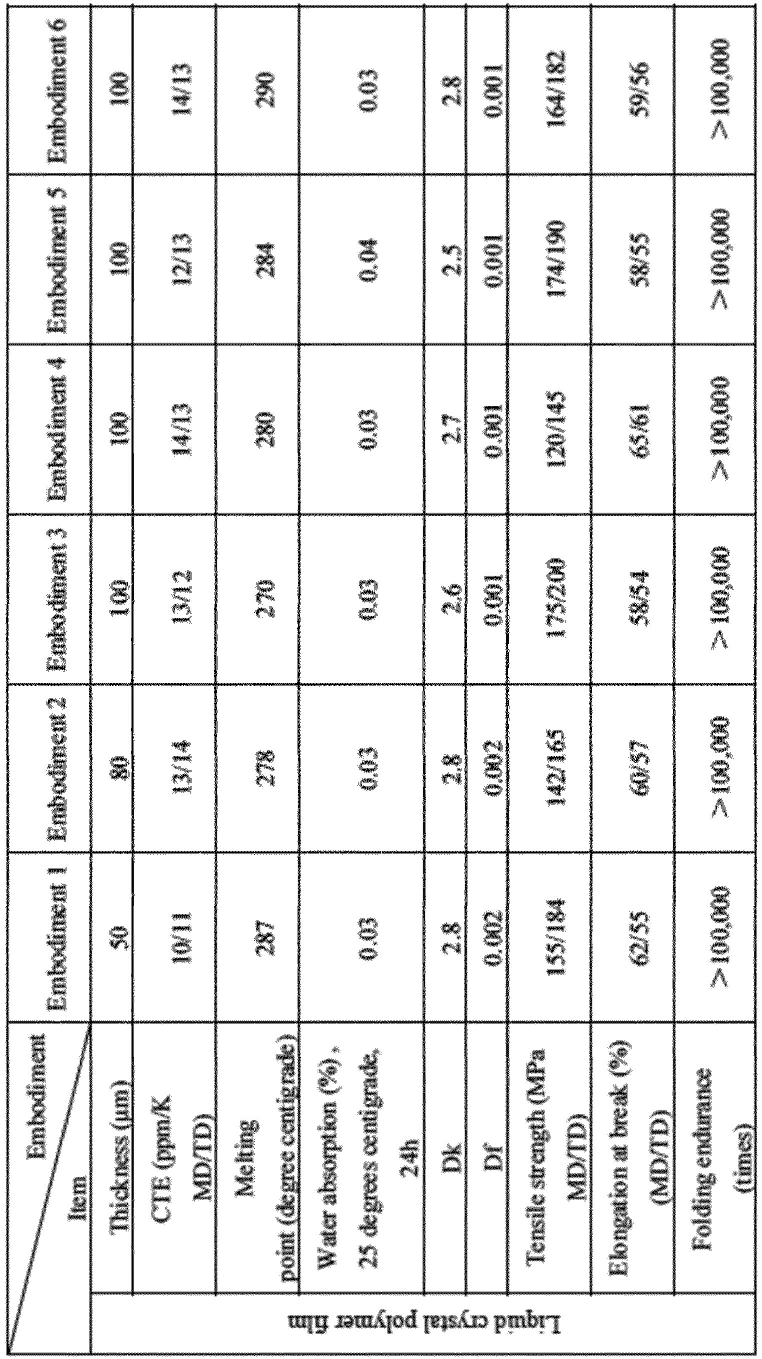

It can be concluded from Table 1 that the liquid crystal polymer film obtained by the preparation method of the present invention not only has an extremely low dielectric constant and an extremely low dielectric dissipation factor, but also has good mechanical properties. When the liquid crystal polymer film is used as a material of the substrate of the flexible printed circuit board, the flexible printed circuit board may have better service performance and longer service life.

The technical features of the above described embodiments may be arbitrarily combined, and all possible combinations of the technical features of the above described embodiments are not described for concise description. However, as long as there is no contradiction in the combinations of these technical features, they should be considered as the scope described in this description.

Those of ordinary skill in the art will recognize that the above embodiments are intended to be illustrative of the present invention only and are not intended to be limiting so long as appropriate changes and variations to the above embodiments fall within the scope of the claims of the present invention within the spirit of the present invention.

## Claims

1. A liquid crystal polymer film for flexible printed circuit board, **characterized in that**
a material of the liquid crystal polymer film comprises an LCP resin and a polyphenylene sulfide resin, wherein a longitudinal tensile strength of the liquid crystal polymer film is less than a transverse tensile strength thereof, and a longitudinal elongation at break of the liquid crystal polymer film is greater than a transverse elongation at break thereof.

2. The liquid crystal polymer film of claim 1, wherein the longitudinal tensile strength of the liquid crystal polymer film is in a range of 0.83 times to 0.92 times of the transverse tensile strength of the liquid crystal polymer film; and/or,
the longitudinal elongation at break of the liquid crystal polymer film is in a range of 1.05 times to 1.13 times of the transverse elongation at break of the liquid crystal polymer film.

3. The liquid crystal polymer film of claim 1, wherein the longitudinal elongation at break of the liquid crystal polymer film is in a range of 55% to 65%, and the transverse elongation at break of the liquid crystal polymer film is in a range of 54% to 61%; and/or,
the longitudinal tensile strength of the liquid crystal polymer film is in a range of 120 MPa to 190 MPa, and the transverse tensile strength of the liquid crystal polymer film is in a range of 145 MPa to 200 MPa.

4. The liquid crystal polymer film of claim 3, wherein a difference value between the longitudinal elongation at break of the liquid crystal polymer film and the transverse elongation at break of the liquid crystal polymer film is in a range of smaller than or equal to 7%.

5. The liquid crystal polymer film of claim 3, wherein a difference value between the transverse tensile strength of the liquid crystal polymer film and the longitudinal tensile strength of the liquid crystal polymer film is in a range of smaller than or equal to 30 MPa.

6. The liquid crystal polymer film of claim 1, wherein under a condition of 50 GHz, a dielectric constant of the liquid crystal polymer film is in a range of 2.5 to 2.8, and a dielectric dissipation factor of the liquid crystal polymer film is in a range of 0.001 to 0.002.

7. The liquid crystal polymer film of claim 1, wherein the liquid crystal polymer film has a coefficient of thermal expansion in a range of 10 ppm/K to 14 ppm/K, and a longitudinal coefficient of thermal expansion of the liquid crystal polymer film is in a range of 90% to 110% times of a transverse coefficient of thermal expansion of the liquid crystal polymer film.

8. The liquid crystal polymer film of claim 1, wherein a mass percentage of the polyphenylene sulfide resin in the liquid crystal polymer film is in a range of 9% to 29.8%.

9. The liquid crystal polymer film of claim 1, wherein the liquid crystal polymer film further comprises an auxiliary, which comprises a compatilizer and a dispersant,
a mass percentage composition of the compatilizer in the liquid crystal polymer film is in a rage of 2% to 5%, and a mass percentage composition of the dispersant in the liquid crystal polymer film is in a rage of 0.2% to 1%.

10. The liquid crystal polymer film of claim 9, wherein the compatilizer comprises a grafted copolymer ethylene-butylene-g-MAH, and a grafting rate of the grafted copolymer ethylene-butylene-g-MAH is greater than or equal to 0.5%.
